# EUROPEAN PATENT SPECIFICATION

(11) **EP 0 563 264 B1**
(45) Date of publication and mention of the grant of the patent: **29.07.1998**
(21) Application number: 92903161.5
(22) Date of filing: 21.11.1991
(51) Int. Cl.: H01L 23/02, H01L 23/498, H01L 23/31

(54) **LEADLESS PAD ARRAY CHIP CARRIER**
KONTAKTSTIFTLOSER CHIP-TRÄGER MIT KONTAKTFELDERN
SUPPORT DE PUCE DU TYPE PLAT A PLAGES DE CONTACT DISPOSEES EN MATRICE

(30) Priority: 21.12.1990 US 631848
(43) Date of publication of application: 06.10.1993
(73) Proprietor: MOTOROLA INC., Fort Lauderdale, FL 33322 (US); Citizen Watch Co., Ltd., Shinjuku-Ku, Tokyo 163-04 (JP)
(72) Inventor: MULLEN, William, B., III, Boca Raton, FL 33428 (US); URBISH, Glenn, F., Coral Springs, FL 33065 (US); FREYMAN, Bruce, J., Tempe, ARIZONA 85283 (US); WALKER, Mauro J., Lake Barrington, ILLINOIS 60010 (US)
(74) Representative: Dunlop, Hugh Christopher
(86) International application number: US9108787
(87) International publication number: WO9211654

(56) References cited:
- EP-A- 0 351 581
- WO-A-90/13991
- US-A- 4 680 617
- US-A- 4 868 349
- US-A- 4 874 722
- US-A- 4 961 105
- PATENT ABSTRACTS OF JAPAN vol. 6, no. 160 (E-126)(1038) 21 August 1982 & JP-A-57 079 652 ( NIPPON DENKI ) 18 May 1982
- IBM TECHNICAL DISCLOSURE BULLETIN vol. 20, no. 10, March 1978, NEW YORK,US page 3872 E. STEPHANS 'pinless module connector'
- PATENT ABSTRACTS OF JAPAN vol. 12, no. 167 (E-610)(3014) 19 May 1988 & JP-A-62 277 753 ( SUMITOMO ) 2 December 1987

## Description

### Technical Field

This invention relates generally to electronic devices, and in particular to packages for semiconductor devices, and most particularly to transfer molded leadless semiconductor packages.

### Background

Pin grid array packages have become a popular form of integrated circuit packaging, as they provide for a large number of pins in a plug-in type package. Patent Abstracts of Japan Vol. 6, No. 160 (E-126) (1038) August 21, 1982 and JP-A-57-79652 show leadless semiconductor packages. An array of pins having a standard spacing (for example, 2.5 mm center to center) is located on a ceramic substrate so that the pins extend outward from one face of the substrate to join with sockets on a main printed circuit board. An integrated circuit or semiconductor device is mounted on the top side of the ceramic substrate and wire bonds are made between the bonding pads of the integrated circuit and the traces on the substrate. The integrated circuit, the leads, and the wire bonds are then covered with an encapsulant to complete the package.

Two types of encapsulation methods have been used. In the first, the integrated circuit chip and associated interconnections are encapsulated in a plastic resin, as in glob top or chip-on-board technology. In the second method, the assembly is encapsulated by transfer molding a thermoset plastic composition over the device and the ceramic substrate. In transfer molding, the assembly to be encapsulated is located inside a metal mold which has recesses defining the shape of the cover to be produced. Solid plastic is heated and forced under pressure through gates into the mold. The heat and pressure causes the plastic to liquify and flow into the mold cavities surrounding the integrated circuit. The mold is heated to cure the plastic and the molded assembly is then removed from the mold. The basic characteristics of transfer molding are taught in U.S. Patent No. 4,460,537.

The structure of a plastic pin grid array assembly is similar to its ceramic equivalent. Instead of using a ceramic substrate, low-cost materials such as epoxy-glass or polyester-glass printed circuit boards are used for the substrate. The fabrication of these substrates shares most of the same assembly processes and techniques with conventional printed circuit board manufacturing processes. The pins of the package are inserted into plated-through holes in the circuit board and either press-fit or reflow soldered.

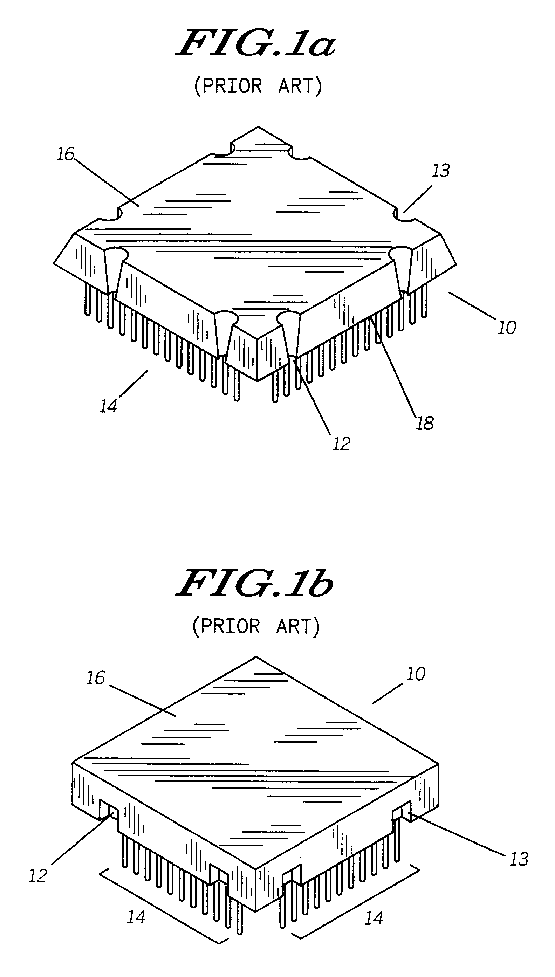

Referring to FIG. 1a and FIG. 1b in the prior art, plastic molded pin grid arrays 10 are formed about a substrate 12 containing an array of pins 14 extending from the bottom of the substrate 12. A plastic compound 16 is transfer-molded about the substrate to form a completed package. The substrate is registered in the mold by locating the edges of the substrate 12 against registration bumps in the mold. After the molding is completed, the registration bumps appear in the finished pin grid array package as indentations or ribs 13. Alternate methods and configurations of forming molded pin grid array packages employ slanted side walls 18 to aid in removal of the molded part from the molding press. Such a transfer-molded plastic pin grid array package is taught in U.S. Patent No. 4,935,581.

The advantages of a plastic pin grid array as compared to a ceramic pin grid array are low cost and better electrical performance. However, despite these advantages, low-density and fragile pins remain major concerns in pin grid array packages. Because of the requirement to attach leaded pins to the substrate, there is an inherent density limitation in pin grid array packages. Conventional packages utilize pins placed at 2.5 mm centers and newer packages promise density increases with 1.25 mm center pins, but at a significant expense. In order to achieve 1.25 mm centers, expensive multilayer substrate construction must be used. In addition, the cost of fabricating and attaching the pins is high. Large pin grid array packages are difficult to assemble into the main circuit board because of bent and skewed package leads. As the size of the package increases, these problems become greatly magnified. The high density 1.25 mm center packages are particularly prone to bent leads due to the small diameter of the leads.

The use of large integrated circuit chips is also restricted when using plastic pin grid array packages. Conventional wisdom dictates that these packages are used only for consumer electronics applications with small integrated circuit chips requiring plug in chip carriers. When larger chips are used, ceramic substrates are employed to accommodate the thermal expansion mismatch between the substrate and the silicon chip. Clearly, a need exists for a low-cost, high density plastic package that would overcome the inherent problems of density, lead fragility, electrical performance, cost, and reliability found in conventional ceramic and printed circuit board pin grid array packages.

### Summary of the Invention

According to a first aspect of the present invention, there is provided a leadless pad array chip carrier package, as claimed in claim 1.

According to a second aspect of the present invention, there is provided a leadless pad array chip carrier package, as claimed in claim 10.

According to a third aspect of the present invention, there is provided a leadless pad array chip carrier package, as claimed in claim 11.

In an alternate embodiment of the invention, solder bumps are formed on the solder pads in order to provide a pad array chip carrier package that is easily soldered to a main circuit board.

### Brief Description of the Drawings

FIG. 1a is a perspective view of a prior art pin grid array package.

FIG. 1b is a perspective cut-away view of a prior art pin grid array package.

FIG. 2 is a perspective view of a resin-molded pad array chip carrier in accordance with the present invention.

FIG. 3 is a plan view of the bottom of a pad array chip carrier in accordance with the present invention.

FIG. 4 is a fragmentary sectional view of FIGS. 2 and 3 through section AA.

FIG. 5 is the same fragmentary sectional view of an alternate embodiment of the invention.

FIG. 6 is the same fragmentary sectional view of another embodiment of the invention.

### Detailed Description of the Preferred Embodiment

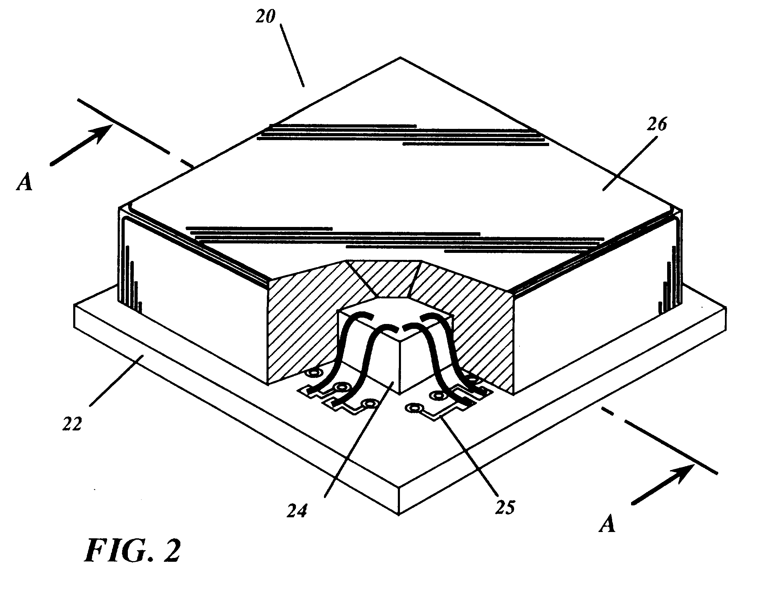

Referring to FIG. 2, a leadless, transfer-molded, pad array chip carrier 20 is made by placing an integrated circuit chip or semiconductor device 24 on a circuit-carrying substrate 22. The circuit carrying substrate is a resinous printed circuit board such as epoxy-glass or polyimide-glass, but may also consist of other materials such as flexible circuitry made from polyimide, polyester, or polyetherimide film. The substrate 22 has a metalization pattern 25 on the upper surface of the substrate. The integrated circuit 24 is adhesively bonded or eutectic bonded to the substrate 22 and wire-bonded to the metallization pattern 25. The integrated circuit 24 may also be attached to the substrate 22 by flip-chip bonding or by tape-automated-bonding (TAB). The substrate and chip assembly is then placed into a molding machine. Typically, a transfer molding machine used, but other methods of molding such as injection molding or reaction injection molding (RIM) may be employed, depending on the materials selected. Transfer molding utilizes thermosetting materials, whereas injection molding utilizes thermoplastic materials and RIM utilizes materials that are thermoplastic but react within the mold to form thermosets. A cover 26 is molded about the chip in order to encapsulate and cover the chip and all the associated interconnections. In practice, the molding compound 26 may extend to the edges of the substrate 22 but will preferably terminate at a distance from the edges of the substrate 22 in order to provide a means for holding or securing the substrate while it is in the mold. By extending the substrate 22 beyond the body of the molding compound 26, the need to have notches or ribs in the molded body (as in the prior art) is obviated.

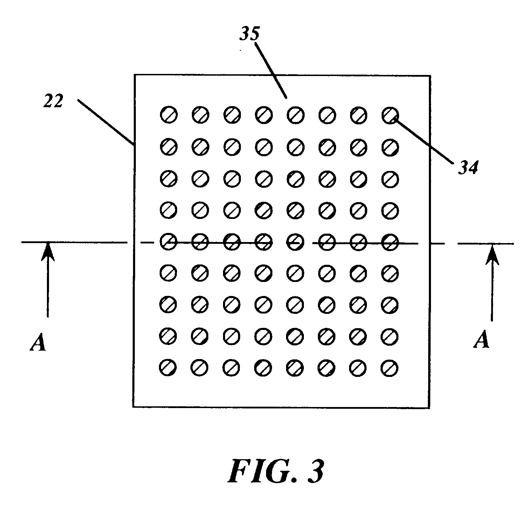

The bottom side of the substrate 22 contains an array 35 of solder pads 34 arranged in a particular configuration (see FIG. 3). The solder pads are typically circular but may assume other shapes. The solder pads 34 serve to provide the electrical interconnection between the pad array chip carrier and a main circuit board (not shown). The solder pads 34 are made from the same metallization as the remainder of the circuit board, typically copper, and may be coated with another material such as gold to prevent oxidation of the solder pads. If the pad array chip carrier is to be soldered to the main printed circuit board, the solder pads may be coated with solder plating or reflowed with solder paste, solder spheres, or other methods to create solder bumps on the solder pads.

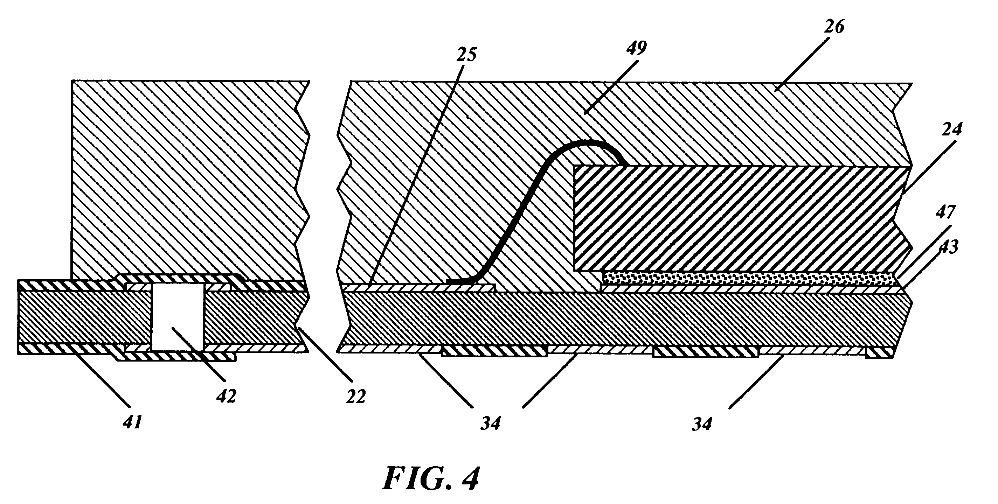

Referring to FIG. 4, the substrate 22 contains a chip bonding metallization pad 43 to which the chip 24 is attached using a conductive adhesive 47. Other means of attachment, such as eutectic bonding, may also be used. The chip is electrically wire-bonded by thin metal wires 49, typically gold or aluminum, to the metallization pattern 25. The electrical connection from the metallization pattern 25 to the solder pads 34 is effected with plated-through holes 42. The metallization pattern 25 on the top surface of the printed circuit board terminates as an annular ring at a plated-through-hole 42. The electrical connection on the bottom side of the printed circuit board is made by connecting the plated-through hole 42 to another annular ring and extending the metallization pattern to the solder pads 34. Typically, a solder mask 41 is placed over the metalization patterns and plated-through-holes 42, but may be eliminated or only partially employed as required. After mounting the chip and making the electrical connections, the assembly is transfer-molded using a thermoplastic or thermoset molding compound, preferably a thermoset epoxy. The molding compound 26 encapsulates the chip 24 and wire-bonds 49, and covers nearly all the top surface of the printed circuit board 22. It can be seen that the upper surface of the printed circuit board is not totally covered by the molding compound, but a small portion around the peripheral edge of the molding compound is left exposed in order to facilitate fixturing the assembly in the mold and subsequent handling during assembly operations. By revealing a portion of the upper surface of the printed circuit board on the perimeter of the chip carrier, the need to provide ribs or indentations in the cover to aid in molding is eliminated. Depending on the configuration desired, the exposed portion of the circuit board can be on one, two. three, or all four sides of the cover.

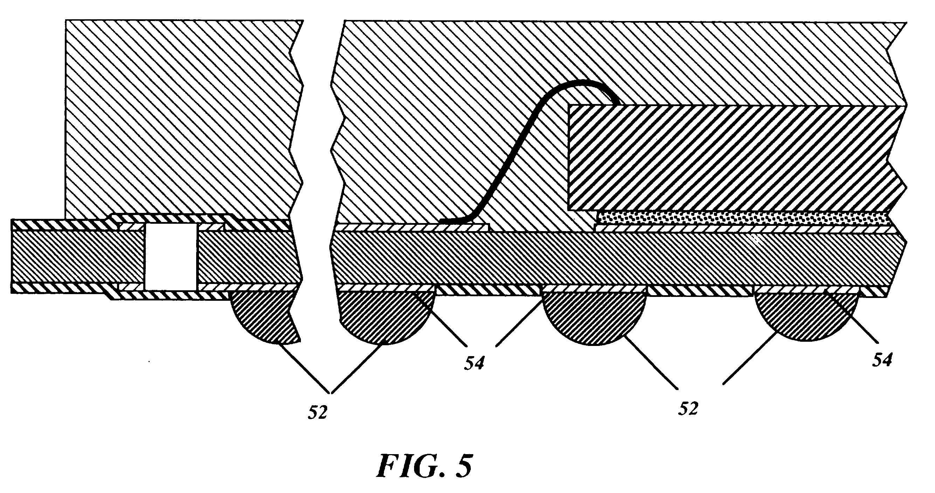

An alternate embodiment of the invention (FIG.5) employs solder bumps 52 on the solder pads 54 to create an array of bumped solder pads. The use of solder bumps allows the pad array chip carrier to be easily soldered to the solder pads on the main circuit board (not shown). The height of the solder bump must be sufficient to effect a surface mount interconnect, typically from about .07mm to .7mm high, and of about the same diameter as the solder pad 54.

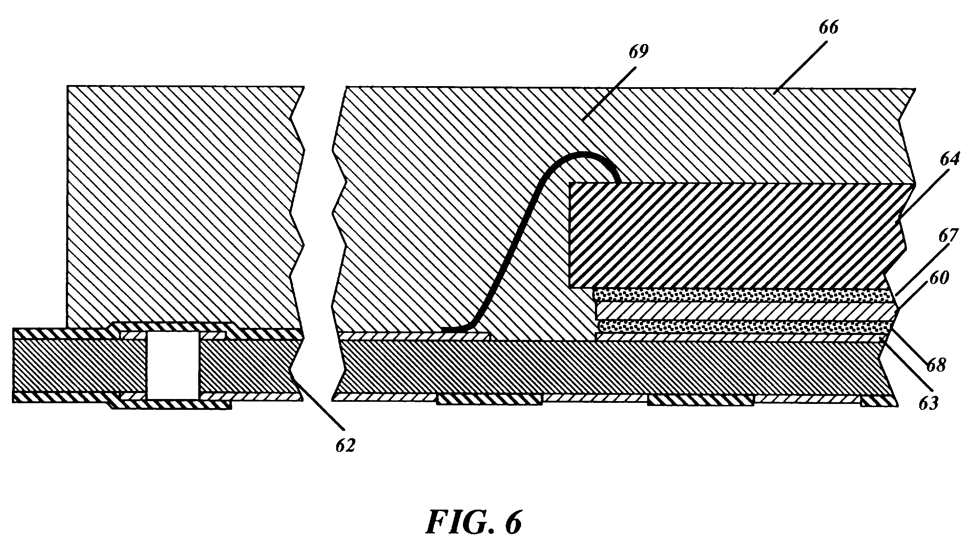

A further embodiment of the invention (FIG. 6) employs a metal member or stiffener 60 made from a thin sheet of a material such as steel, nickel, cooper clad invar, alloy 42, or other materials having a flexural modulus in excess of about 13,000 megapascal. The thickness of the stiffener varies from about 0.08 to about 0.25 mm depending of the type of material used. The stiffener is adhesively bonded to the pad 63 of the printed circuit board 62 using an adhesive material 68. The chip 64 is then attached to the stiffener 60 using a conductive adhesive 67 as in the previous example. The metal stiffener acts to reduce the mechanical stress imparted by the mismatch between the thermal expansion coefficients of the printed circuit board and the silicon chip. By reducing this stress, larger integrated circuit chips may be used in the plastic pad array chip carrier package. Electrical connections are made between the chip and the circuit board 62 by wire bonds 69 in the same manner as the earlier embodiment. A cover 66 is molded as in the previous example to encapsulate the integrated circuit 64, the wire bonds 69, the stiffener 60, and the top surface of the printed circuit board 62.

Further increases in density may be achieved by using multi-layer circuit board construction and blind vias. By eliminating the need for pins, chip carriers with interconnection spacing as small as twenty mils center-to-center may be achieved. Larger integrated circuits may be mounted and encapsulated, and a low cost package can be easily fabricated.

Various changes and modifications in the pad array chip carrier herein disclosed may occur to those skilled in the art; and to the extent that such changes and modifications are embraced by the appended claims, it is to be understood that they constitute part of the present invention.

## Claims

1. A leadless pad array chip carrier package (20) comprising:
a leadless circuit-carrying insulating substrate (22) having opposing planar first and second sides;
a semiconductor device (24) electrically and mechanically mounted on the first side of the circuit-carrying substrate;
a first metalisation pattern (25) on the first side electrically connecting the semiconductor device (24) to vias (42) through the circuit-carrying substrate (22);
the second substrate side carrying a substantially coplanar array of surface mount solder pads (34) with a portion of the array being disposed below the device (24), and each of the pads of the arrays being positioned away from the vias (42);
a second metalisation pattern on the second side of the circuit-carrying substrate (22) electrically connecting the vias (42) to the solder pads (34); and
a protective cover (26) of resin molded about the device (24) and covering a portion of the first side to form a leadless pad array chip carrier (20).

2. The leadless pad array chip carrier (20) package of claim 1, wherein the protective cover (26) is smaller than the leadless circuit carrying insulating substrate (22), thereby exposing a portion of the first side of the leadless circuit carrying substrate (22) about a perimeter of the protective cover (26).

3. The leadless pad array chip carrier package (20)of claim 1 or claim 2, wherein the leadless circuit carrying insulating substrate (22) is a glass reinforced printed circuit board

4. The leadless pad array chip carrier package (20) of any of the preceding claims, wherein the leadless circuit carrying insulating substrate (22) is a flexible film.

5. The leadless pad array chip carrier package (20) of claim 4, wherein the flexible film is selected from the group consisting of polyimide, polyester, or polyetherimide.

6. The leadless pad array chip carrier package (20) of any of the preceding claims, wherein the semiconductor device (24) is wirebonded to the leadless circuit carrying insulating substrate (22).

7. The leadless pad array chip carrier package (20) of any of the preceding claims, wherein the semiconductor device (24) is tape automated bonded (TAB) to the leadless circuit carrying insulating substrate (22).

8. The leadless pad array chip carrier package (20) of any of the preceding claims, wherein the semiconductor device (24) is directly attached to the leadless circuit carrying insulating substrate.

9. The leadless pad array chip carrier package (20) of any of the preceding claims, wherein the protective cover (26) is a thermosetting resin or a thermoplastic resin.

10. The leadless pad array chip carrier package (20) of any of the preceding claims further comprising solder bumps (54) on the solder pads (34).

## Patentansprüche

1. Kontaktstiftlose Padmatrix-Chipträgerverpackung (20) mit:
einem kontaktstiftlosen schaltungstragenden isolierendem Substrat (22) mit gegenüberliegenden planaren ersten und zweiten Seiten;
einer Halbleitervorrichtung (24) welche elektrisch und mechanisch auf die erste Seite des schaltungstragenden Substrats angebracht ist;
einem ersten Metallisierungsmuster (25) auf der ersten Seite zum elektrischen Verbindung der Halbleitervorrichtung (24) mit Durchgängen (42) durch das schaltungstragende Substrat (22);
wobei die zweite Substratseite eine im wesentlichen koplanare Matrix von Oberflächenanbringungs-Lotpads (34) trägt, wobei ein Teil der Matrix unterhalb der Vorrichtung (24) angeordnet ist und wobei jedes der Pads der Matrix von den Durchgängen (42) entfernt positioniert ist;
einem zweiten Metallisierungsmuster auf der zweiten Seite des schaltungstragenden Substrats (22) zum elektrischen Verbinden der Durchgänge (42) mit den Lotpads (34); und
einer Schutzabdeckung (26) aus Harz, welche um die Vorrichtung (24) geformt ist und einen Teil der ersten Seite bedeckt, um einen kontaktstiftlosen Padmatrix-Chipträger (20) zu bilden.

2. Kontaktstiftlose Padmatrix-Chipträgerverpackung (20) nach Anspruch 1, dadurch gekennzeichnet, daß die Schutzabdeckung (26) kleiner als das kontaktstiftlose schaltungstragende isolierende Substrat (22) ist, um so einen Teil der ersten Seite des kontaktstiftlosen schaltungstragenden Substrats (22) um einen Umfang der Schutzabdeckung (26) freizulassen.

3. Kontaktstiftlose Padmatrix-Chipträgerverpackung (20) nach Anspruch 1 oder 2, dadurch gekennzeichnet, daß das kontaktstiftlose schaltungstragende isolierende Substrat (22) eine glasverstärkte gedruckte Schaltungsplatte ist.

4. Kontaktstiftlose Padmatrix-Chipträgerverpackung (20) nach einem der vorhergehenden Ansprüche, wobei das kontaktstiftlose schaltungstragende isolierende Substrat (22) ein flexibler Film ist.

5. Kontaktstiftlose Padmatrix-Chipträgerverpackung (20) nach Anspruch 4, dadurch gekennzeichnet, daß der flexible Film aus folgender Gruppe ausgebildet ist: Polyimid, Polyester oder Polyetherimid.

6. Kontaktstiftlose Padmatrix-Chipträgerverpackung (20) nach einem der vorhergehenden Ansprüche, dadurch gekennzeichnet, daß die Halbleitervorrichtung (24) auf das kontaktstiftlose schaltungstragende isolierende Substrat (22) drahtbondiert ist.

7. Kontaktstiftlose Padmatrix-Chipträgerverpackung (20) nach einem der vorhergehenden Ansprüche, dadurch gekennzeichnet, daß die Halbleitervorrichtung (24) bandautomatisiert auf das kontaktstiftlose schaltungstragende isolierende Substrat (20) bondiert (TAB) ist.

8. Kontaktstiftlose Padmatrix-Chipträgerverpackung (20) nach einem der vorhergehenden Ansprüche, dadurch gekennzeichnet, daß die Halbleitervorrichtung (24) direkt an dem kontaktstiftlosen schaltungstragenden isolierenden Substrat angebracht ist.

9. Kontaktstiftlose Padmatrix-Chipträgerverpackung (20) nach einem der vorhergehenden vorherigen Ansprüche, dadurch gekennzeichnet, daß die Schutzabdeckung (26) ein Hitzehärtungsharz oder ein thermoplastisches Harz ist.

10. Kontaktstiftlose Padmatrix-Chipträgerverpackung (20) nach einem der vorhergehenden Ansprüche, gekennzeichnet durch Lothügel (54) auf den Lotpads (34).

## Revendications

1. Boîtier de support de microplaquette à réseau de plots montée en surface (20) comprenant :
- un substrat isolant de support de circuit monté en surface (22) possédant des premier et second côtés plans en opposition;
- un dispositif de semi-conducteur (24) monté, de façon électrique et mécanique, sur le premier côté du substrat de support de circuit;
- un premier motif de métallisation (25) sur le premier côté raccordant, de façon électrique, le dispositif de semi-conducteur (24) à des passages (42) traversant le substrat de support de circuit (22);
le second côté de substrat portant un agencement pratiquement coplanaire de plots de soudage de montage en surface (34) avec une partie de l'agencement disposée en dessous du dispositif (24) et chacun des plots de la configuration étant positionné à l'écart des passages (42);
- un second motif de métallisation sur le second côté du substrat de support de circuit (22) raccordant, de façon électrique, les passages (42) aux plots de soudage (34); et
- un couvercle de protection (26) en résine moulée autour du dispositif (24) et couvrant une partie du premier côté pour former un support de microplaquette à plots montée en surface (20).

2. Boîtier de support de microplaquette à réseau de plots montée en surface (20) selon la revendication 1, dans lequel le couvercle de protection (26) est plus petit que le substrat isolant de support du circuit monté en surface (22), exposant ainsi une partie du premier côté du substrat de support de circuit monté en surface (22) selon un périmètre du couvercle de protection (26).

3. Boîtier de support de microplaquette à réseau de plots montée en surface (20) selon la revendication 1 ou 2, dans lequel le substrat isolant de support de circuit monté en surface (22) est une plaque de circuit imprimé renforcée par du verre.

4. Boîtier de support de microplaquette à réseau de plots montée en surface (20) selon l'une quelconque des revendications précédentes, dans lequel le substrat isolant de support de circuit monté en surface (22) est un film flexible.

5. Boîtier de support de microplaquette à réseau de plots montée en surface (20) selon la revendication 4, dans lequel le film flexible est sélectionné dans le groupe comprenant le polyimide, le polyester ou le polyétherimide.

6. Boîtier de support de microplaquette à réseau de plots montée en surface (20) selon l'une quelconque des revendications précédentes, dans lequel le dispositif de semi-conducteur (24) est lié par câblage au substrat isolant de support de circuit monté en surface (22).

7. Boîtier de support de microplaquette à réseau de plots montée en surface (20) selon l'une quelconque des revendications précédentes, dans lequel le dispositif de semi-conducteur (24) est lié de façon automatisée par bande (TAB) au substrat isolant de support de circuit monté en surface (22).

8. Boîtier de support de microplaquette à réseau de plots montée en surface (20) selon l'une quelconque des revendications précédentes, dans lequel le dispositif de semi-conducteur (24) est directement fixé au substrat isolant de support de circuit monté en surface (22).

9. Boîtier de support de microplaquette à réseau de plots montée en surface (20) selon l'une quelconque des revendications précédentes, dans lequel le couvercle de protection (26) est une résine thermodurcissable ou une résine thermoplastique.

10. Boîtier de support de microplaquette à réseau de plots montée en surface (20) selon l'une quelconque des revendications précédentes, comprenant, de plus, des bossages de soudage (54) sur les plots de soudage (34).
